# EUROPEAN PATENT APPLICATION

(11) **EP 4 819 768 A1**
(43) Date of publication of application: **07.10.2026**
(21) Application number: 26165964.3
(22) Date of filing: 19.03.2026
(51) Int. Cl.: H05K 1/02, H05K 1/11, H05K 1/14, H05K 3/42, H05K 3/341

(54) **COMPONENT CARRIER AND METHOD OF DESIGNING AND MANUFACTURING A COMPONENT CARRIER**

(30) Priority: 31.03.2025 CN 202510399635
(71) Applicant: AT & S Austria Technologie & Systemtechnik Aktiengesellschaft, 8700 Leoben-Hinterberg (AT)
(72) Inventor: KOESEMEK, Cem Özgür, 8523 Frauental an der Laßnitz (AT); FREWEIN, Markus, 8010 Graz (AT); WENINGER, Markus, 8700 Leoben (AT); LIU, Truman, 10250 George Town, Pulau Pinang (MY)
(74) Representative: Donatello, Daniele

(57) **Abstract**

The present application relates to a component carrier and a method of designing and manufacturing a component carrier. The component carrier comprises a layer stack, a plurality of electrically conductive external connecting elements on and/or in one main surface of the layer stack, wherein each pair of adjacent ones of the plurality of external connecting elements are horizontally separated by a spacing extending along a virtual connection axis passing through centers of both adjacent external connecting elements of each respective pair, and at least one internal stack (116, 117)of stacked vertical connection elements, the internal stack(118, 119)extending internally of the layer stack , the stacked vertical connection elements being directly connected to an electrically conductive exterior surface of the layer stack in contact with a respective the external connecting elements, wherein at least one of the stacked vertical connection element (118, 119)of the internal stack (116, 117) is horizontally shifted away from the virtual connection axis(118, 119)(116, 117).

## Description

The invention relates to a component carrier, and to a method of designing and manufacturing a component carrier.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

It is an object of the invention to provide a reliable component carrier.

In order to achieve the object defined above, a component carrier and a method of designing and manufacturing a component carrier according to the present application are provided.

According to an exemplary embodiment, a component carrier is provided which comprises a layer stack which comprises at least one electrically conductive layer structure and at least one electrically insulating layer structure, a plurality of electrically conductive external connecting elements on and/or in one main surface of the layer stack, wherein each pair of adjacent ones of said plurality of external connecting elements are horizontally separated by a spacing extending along a virtual connection axis passing through centers of both adjacent external connecting elements of each respective pair, and at least one internal stack of stacked vertical connection elements, the internal stack extending internally of the layer stack, the stacked vertical connection elements directly connected to an electrically conductive exterior surface of the layer stack in contact with a respective one of said external connecting elements, wherein at least one of the stacked vertical connection elements of a respective one of the at least one internal stack is horizontally shifted away from the virtual connection axis, for example with respect to at least one other of the stacked vertical connection elements of said internal stack.

According to another exemplary embodiment of the invention, a method of designing and manufacturing a component carrier is provided, wherein the method comprises virtually specifying the component carrier with a layer stack which comprises at least one electrically conductive layer structure and at least one electrically insulating layer structure, a plurality of electrically conductive external connecting elements on and/or in one main surface of the layer stack, and at least one internal stack of stacked vertical connection elements, the internal stack extending internally of the layer stack the stacked vertical connection elements being directly connected to an electrically conductive exterior surface of the layer stack in contact with a respective one of said external connecting elements, parameterizing position, shape and/or dimensions of the electrically conductive external connecting elements, the stacked vertical connection elements, and/or the electrically conductive exterior surface, simulating stress exerted to the virtually specified component carrier based on the parameterized position, shape and/or dimensions, virtually modifying, in accordance with a result of the simulating, the parameterized position, shape and/or dimensions for reducing simulated stress exerted to the virtually specified component carrier, and physically manufacturing the component carrier using the modified parameterized position, shape and/or dimensions.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "layer stack" may particularly denote an arrangement of multiple planar layer structures which are mounted in parallel on top of one another. For instance, the layer structures of the layer stack may be laminated, i.e. connected by the application of elevated temperature and/or pressure.

In the context of the present application, the term "layer structure" may particularly denote a continuous layer, a patterned layer or a plurality of nonconsecutive islands within a common plane.

In the context of the present application, the term "electrically conductive external connecting element" may particularly denote a physical structure comprising an electrically conductive material and being arranged to electrically and mechanically connect a peripheral electronics with at least one internal stack having vertical connection elements of a component carrier. For example, the electrically conductive external connecting element may comprise a solder structure (such as a solder bumps), a sinter structure, a structure of electrically conductive glue, etc. The peripheral electronics may for instance comprise an electronic component, in particular a surface mounted electronic component, such as a semiconductor die. It is also possible that the peripheral electronics comprises an electronic board (such as a printed circuit board, an integrated circuit substrate and/or an interposer) to which the component carrier is to be connected.

In the context of the present application, the term "center of an electrically conductive external connecting element" may particularly denote a symmetry point or symmetry axis or a center of gravity of the electrically conductive external connecting element.

In the context of the present application, the term "external connecting elements horizontally separated by a spacing extending along a virtual connection axis passing through centers of the external connecting elements" may particularly denote a configuration in which the external connecting elements are spaced or distanced from each other by a spacing or distance corresponding to the length of a virtual rather than physical straight line between their centers. The horizontal plane may correspond to a main surface of the layer stack at which the external connecting elements may be arranged.

In the context of the present application, the term "internal stack of stacked vertical connection elements" may particularly denote an array of vertically stacked connection elements in an interior of the layer stack, ending for instance at the electrically conductive exterior surface of the layer stack. The vertically stacked connection elements may comprise cylindrical structures (for instance metal-filled mechanical drill holes, plated through holes, etc.), frustoconical structures (in particular metal-filled laser vias), cuboid structures (for example a metal pillar with rectangular cross-section, metallic inlay blocks), etc. Said connection elements may be electrically conductive, in particular metallic, for instance made of copper.

In the context of the present application, the term "electrically conductive exterior surface" may particularly denote a surface portion of the layer stack delimited by electrically conductive material and forming an electrical and mechanically interface between external connecting elements and an internal stack of vertical connection elements.

In the context of the present application, the term "a vertical connection element horizontally shifted away from a virtual connection axis" may particularly denote that, in a plan view of the layer stack along a stacking direction of the vertical connection elements of a respective internal stack, a center (such as a symmetry point or axis or a center of gravity) of said vertical connection element or even the entire outline of the vertical connection element is arranged outside of the virtual (rather than physical) connection axis connecting a pair of external connecting elements. Thus, said vertical connection element may be displaced within a horizontal plane away from said virtual connection axis.

In the context of the present application, the term "a vertical connection element horizontally shifted away from a virtual connection axis with respect to another vertical connection element" may particularly denote that the first mentioned vertical connection element is shifted away from said virtual connecting axis in a plan view on a horizontal plane, whereas the latter mentioned other vertical connection element may have a center (such as a symmetry point or axis or a center of gravity) displaced in the horizontal plane with respect to a center (such as a symmetry point or axis or a center of gravity) of the first mentioned vertical connection element. In particular, such a center or an entire outline of the latter mentioned vertical connection element may be on or may intersect the virtual connection axis.

In the context of the present application, the term "method of designing and manufacturing a component carrier" may particularly denote a process encompassing both a theoretical definition of the characteristics (such as a set of parameter values, for instance including positions and dimensions, as well as materials) of a component carrier to be manufactured, and the subsequent process of physically manufacturing the component carrier on the basis of the defined characteristics.

In the context of the present application, the term "virtually specifying the component carrier" may particularly denote a theoretical process of defining properties, kind and number of constituents, a relationship between different constituents and construction of the component carrier to be designed and manufactured. For instance, said process may be controlled by a component carrier designer, software-based, and/or artificial intelligence-supported.

In the context of the present application, the term "parameterizing position, shape and/or dimensions of electrically conductive external connecting elements, stacked vertical connection elements, and/or an electrically conductive exterior surface" may particularly denote a process in which initial or draft parameter values of the mentioned virtual constituents of the component carrier to be designed and manufactured are defined. For instance, said process may be controlled by a component carrier designer, software-based, and/or artificial intelligence-supported.

In the context of the present application, the term "simulating stress exerted to the virtually specified component carrier based on the parameterized position, shape and/or dimensions" may particularly denote execution of a numerical, mathematical or software-based simulation of thermal and/or mechanical stress (such as forces, strain, tensile load) which the theoretically defined component carrier experiences during manufacture, electric operation, thermal cycles, etc. For this simulation, physical laws, expert knowledge, empirical data, a simplifying model, etc., may be used. A simulation software, a finite element analysis, a Monte Carlo method, etc. may be carried out.

In the context of the present application, the term "virtually modifying, in accordance with a result of the simulating, the parameterized position, shape and/or dimensions for reducing simulated stress exerted to the virtually specified component carrier" may particularly denote a process of changing one or more parameterization values specifying the component carrier to be designed and manufactured under consideration of the results of the stress simulation in an attempt to reduce (in particular simulated) stress by modified parameter values. This process may include the modification of size, position and/or material of individual constituents of the component carrier, and/or the mutual relationship between such different constituents. This modification may be an iterative process comprising one or more iterations for improving the stress behavior. For instance when compliance with a predefined target behavior (for instance compliance with a predefined stress threshold level) has been achieved, or when an optimal behavior has been achieved (for instance a stress minimum), the modification process may be completed and its result may be accepted as a basis for the subsequent physical manufacture of the so designed component carrier.

In the context of the present application, the term "physically manufacturing the component carrier" may particularly denote an actual process of producing a physical body forming a component carrier, such as a printed circuit board or an integrated circuit substrate. For instance, the physical manufacture of the component carrier may comprise one or more of the processes of laminating layer structures, drilling holes (for instance by laser processing and/or by using a mechanical drill bit), forming horizontal and/or vertical metallic structures (for instance using electroless plating and/or electroplating), depositing or dispensing material (for instance depositing solder bumps, surface finish and/or solder resist, or dispensing electrically conductive paste for forming a conductive through connection), etching structures (for instance wet etching or plasma etching), carrying out photolithography, assembling electronic components (for instance by embedding in the layer stack and/or by surface mounting on the layer stack), etc.

In the context of the present application, the term "main surface" of a body may particularly denote one of two largest opposing surfaces of the body or outermost opposing surfaces of the body. The main surfaces may be connected by circumferential side walls. The thickness of a body, such as the component carrier or the stack, may be defined by the distance between the two opposing main surfaces.

According to an exemplary embodiment, a component carrier (such as a PCB or an IC substrate) may be provided with a (preferably laminated) layer stack of one or more electrically conductive layer structures (such as patterned copper layers connected with copper vias) and one or more electrically insulating layer structures (for instance prepreg sheets). Electrically conductive external connecting elements (such as exterior solder bumps) at a main surface of the layer stack may be mutually spaced along a horizontal virtual connection axis on said main surface. At least one vertical connection element of an internal stack forming part of the layer stack and being connected with a respective external connecting element may be shifted away from said virtual connection axis. Simulations have shown that such a shifting may significantly reduce stress in an interior of the corresponding component carrier. Consequently, a physically manufactured component carrier having such a shifted vertical connection element may be exerted to significantly reduced component carrier internal stress and may therefore improve crack resistance and/or suppress undesired phenomena such as warpage and delamination. As a result, a component carrier with improved reliability and performance may be manufactured. Preferably but not necessarily, said shifting of said vertical connection element may also be a shift with respect to another of stacked vertical connection elements of said internal stack. The latter mentioned other stacked vertical connection element may or may not remain aligned with said vertical connection axis. Using this additional design parameter, stress may be further reduced.

Correspondingly, exemplary embodiments may provide a method of designing and manufacturing a component carrier of the aforementioned type. In this context, it may be possible to virtually specify the component carrier with the above-mentioned layer stack, external connecting elements, and stacked vertical connection elements. The method may further define initial parameters concerning position, shape and/or dimensions of the mentioned constituents. On the basis of this definition, mechanical and/or thermal stress exerted to the still virtually specified component carrier may be simulated, for instance by modeling the component carrier under development taking into account physical boundary conditions (which may be reflected by laws of nature, expert rules, empirical data, former simulation results, etc.). The parameterization may then be modified under consideration of a result of the stress simulation, in an attempt to reduce or further stress, and the stress simulation may be repeated with the modified parameterization once or multiple times, for instance in an iterative process. Advantageously, said modification may for example comprise a mutual shift of individual ones or groups of stacked vertical connection elements with respect to a virtual connection axis connecting external connecting elements. When an acceptable stress level has been achieved theoretically by a simulation based on a modified set of parameters defining a component carrier, the corresponding component carrier using the modified parameterization may be physically manufactured. Advantageously, this may allow to provide a reliable component carrier in a simple way.

In the following, further exemplary embodiments of the component carrier and the method will be explained.

In an embodiment, a plurality of the stacked vertical connection elements overlap, in particular are aligned with, the virtual connection axis. It has been found that even shortening the length of the connection due to the respective overlapping and/or alignment, such an overlap or alignment may have an impact on stress, so that a corresponding adjustment may lead to an improvement of reliability of the component carrier.

In an embodiment, a majority of the stacked vertical connection elements overlap, in particular are aligned with, the virtual connection axis. In particular, a majority may be more than 50%, in particular more than 70% of the stacked vertical connection elements.

In an embodiment, a sub-set of the stacked vertical connection elements which are located closer to the external connecting elements in a viewing direction corresponding to a layer stack thickness direction than another sub-set of the stacked vertical connection elements overlap, in particular are aligned with the virtual connection axis. To put it shortly, said viewing direction may be a vertical direction of the component carrier. Overlapping or aligning the closer vertical connection elements with the virtual connection axis may have a positive impact in terms of the connection length, reducing at the same time stress, in particular for those vertical connection elements being located closer than others to an external connecting element. This may be due the stiffening effect imparted by said connecting element, which when being stiffer than the stacked layers, it enhances the stiffness of the proximate portion of said stacked layer, then overcoming or reducing stress caused by the closer aligned sub-set of the stacked vertical connection elements.

In an embodiment, one of the at least one electrically conductive layer structure electrically connects one, some or all of the at least one shifted stacked vertical connection elements. In particular, the electrically conductive layer structures may define metallic pads between adjacent metallized laser vias of the stacked vertical connection elements. This may bring the advantage of transmitting electrical current through the vertical connection elements in addition to imparting physical properties, for example stiffness, to the stack.

In an embodiment, a first sub-set of said stacked vertical connection elements overlap each other in a viewing direction corresponding to a layer stack thickness direction, and a second sub-set of other ones of said stacked vertical connection elements are shifted and overlap each other in the viewing direction corresponding to the layer stack thickness direction. In particular, the first sub-set of said stacked vertical connection elements may be not horizontally shifted away from the virtual connection axis. For instance, a part of the stacked vertical connection elements may be arranged displaced from the virtual connection axis and overlapping with at least one other vertical connection element, whereas another part of the stacked vertical connection elements may be arranged overlapping but non-shifted. This introduces a further design parameter for reducing stress, in particular for reducing the stress on the intermediate layers of a build-up where said shifted second sub-set of other ones of said stacked vertical connections pass through, forming a dumping stress release depth portion of the build-up between its two opposed main surfaces.

In an embodiment, the at least one shifted of the stacked vertical connection elements is arranged more centrally in layer stack thickness direction than at least one other, in particular non-shifted, of the stacked vertical connection elements being arranged more peripherally in layer stack thickness direction. For example, the at least one shifted vertical connection element may be at least one plated through hole arranged in a core of the layer stack, whereas one or more non-shifted vertical connection elements may be metallized laser vias in a build-up on one or both opposing main surfaces of such a core. The central position of the shifted stacked vertical connection elements may enhance the release of the stress at the central portion of the stack-build-up acting as an intermediate stress dumping volume.

In an embodiment, each one of the pair of adjacent external connecting elements are connected to a respective stacked vertical connection element. Hence, an electrically conductive path may be formed from the stacked vertical connection elements (in particular at least one plated through hole connected with at least one metallized laser via) of the one or more internal stacks via the electrically conductive exterior surface to the external connecting elements. Within this partially horizontal and partially vertical electric path, mutual shifting of the individual electrically conductive elements, in particular in relation to a virtual connection axis between external connecting elements, may be done for reducing stress, in particular created by the planar irregular distribution of two (in particular adjacent) stacked vertical connection elements, inhibiting cracks.

In an embodiment, stacked vertical connection elements of an internal stack are connected with each other through at least one of said at least one electrically conductive layer structure. This may be done for example between vertically adjacent vertical connection elements, said pads being formed as flat (for instance circular) substructures of a patterned electrically conductive layer structure. The connection of vertical connection element of an internal stack with each other through at least one of said at least one electrically conductive layer structure may impart a higher stiffness to the internal stack and thus may reduce the stress acting on the electrically conductive external connecting elements.

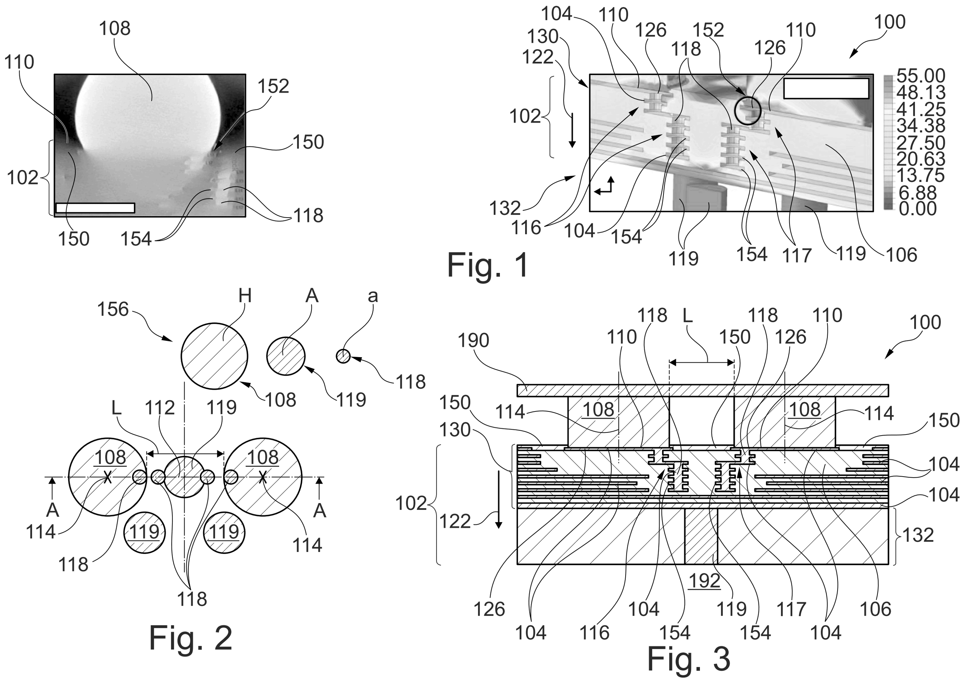

In an embodiment, at least one of said vertical connection elements located closer to a respective external connecting element is located closer to a center of said external connecting element in a viewing direction corresponding to a layer stack thickness direction than at least one of said vertical connection elements located further away from said external connecting element. As shown for instance in Figure 3, a staggered arrangement of vertical connection elements starting from at least one of them being arranged remote from the external connecting elements may extend up to the external connecting elements in a laterally extending or expanding way. Such an arrangement may be advantageous in terms of reliability improvement. On the other hand, providing the vertical connection elements located closer to a respective external connecting element in a closer planar position with respect to the center of said external connecting element means to place said vertical connection elements in the stiffener part of the stack. When the latter are affected by the stiffness of the external connecting element, then a hiding of the stress caused by said vertical connection elements may occur.

In an embodiment, the at least one of said vertical connection elements located closer overlaps, in particular fully overlaps, in the viewing direction corresponding to the layer stack thickness direction, with the horizontal extension of said external connecting element. Again referring for instance to Figure 2 and Figure 3, it may be possible that the outermost vertical connection elements fully overlap with the neighbored external connecting elements for achieving a low ohmic short connection path, placing the external vertical connection elements in the stack having the highest stiffness.

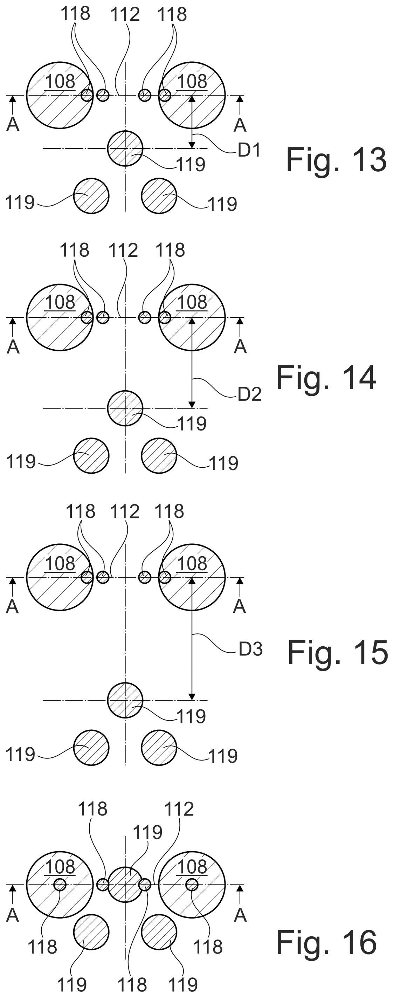

In an embodiment, one, two or more of the stacked vertical connection elements being located closest to a respective external connecting element is or are vertically aligned with said external connecting element in a layer stack thickness direction. Such an alignment may be obtained by parallel and mutually displaced central axes of a respective vertical connection element and an assigned external connecting element (see for instance Figure 2) or even by coaxial central axes (as for instance in Figure 16). Such an arrangement may reduce the stress on the electrically conductive external connecting element (in particular to a minimum).

In an embodiment, said one, two or more of the stacked vertical connection elements and the respective external connecting element are coaxial and/or overlap with each other with an overlapping area being at least 80% of the entire area of the respective vertical connection element in a viewing direction corresponding to the layer stack thickness direction. According to Figure 2, the overlapping surface may even be 100% of the area of the first vertical connection element. Such an arrangement may increase or even maximize the stress release from the stacked vertical connection elements by the imparted high stiffness of the respective external connecting element.

In an embodiment, the component carrier comprises at least two of said internal stacks, wherein for each of said internal stacks one, two or more of the respective stacked vertical connection elements being located closest to a respective external connecting element is or are vertically aligned with said external connecting element in a layer stack thickness direction. The different internal stacks may be electrically decoupled from each other. Alternatively, the different internal stacks may be electrically coupled with each other. An alignment may be achieved between the outermost vertical connection element(s) of each internal stack and an assigned external connecting element. Symmetrical and/or counter- design may distribute the stress on the plurality of electrically conductive external connecting elements and thus a local stress may act on each respective electrically conductive external connecting element.

In an embodiment, at least one of one or more central layers of the layer stack comprises at least one conductive through connection passing through the respective central layer, said at least one conductive through connection belonging to or being connected to the stacked vertical connection elements. Said at least one central layer may comprise a core. One or more plated through holes may extend vertically through said core and may form a respective vertical connection element. Even conductive through connections passing through the respective central layer may have a positive impact on the stress reduction acting on the electrically conductive external connection element.

In an embodiment, a cross-sectional area of a respective conductive through connection in a horizontal plane is larger than a cross-sectional area of a respective other one or a respective one of said stacked vertical connection elements in the horizontal plane. For instance, a horizontal outline of a solder bump may be larger than a horizontal outline of a metallized laser via. By varying the cross-sectional area of a respective conductive through connection the stress acting on the electrically conductive external connection element may be tuned. Thus by choosing properly the cross-sectional area of a respective conductive through connection the stress acting on the electrically conductive external connection element may be reduced.

In an embodiment, a cross-sectional area of a respective conductive through connection in a horizontal plane is smaller than a cross-sectional area of a respective external connecting element in the horizontal plane. For example, a horizontal outline of a solder bump may be larger than a horizontal outline of a plated through hole.

In an embodiment, at least one conductive through connection is horizontally shifted away from the virtual connection axis. For instance, Figure 2 shows this for a subset of plated through holes. This configuration may at least partially guide the stress away from the electrically conductive external connection element. In particular, due to the dimensions and position of the at least one conductive through connection, the stress imparted at the opposed side of the build-up where the external connecting elements are provided may be strongly reduced.

In an embodiment, at least one conductive through connection is overlapping with, in particular is centered at, the virtual connection axis in a viewing direction corresponding to a layer stack thickness direction. For example, Figure 2 illustrates this for one plated through hole. Depending on the position of the other conductive through connection(s) (preferably shifted from the or any virtual connection axis), this configuration may distribute the stress on at least two of the plurality of electrically conductive external connecting elements and thus may reduce the stress acting on the respective electrically conductive external connecting element.

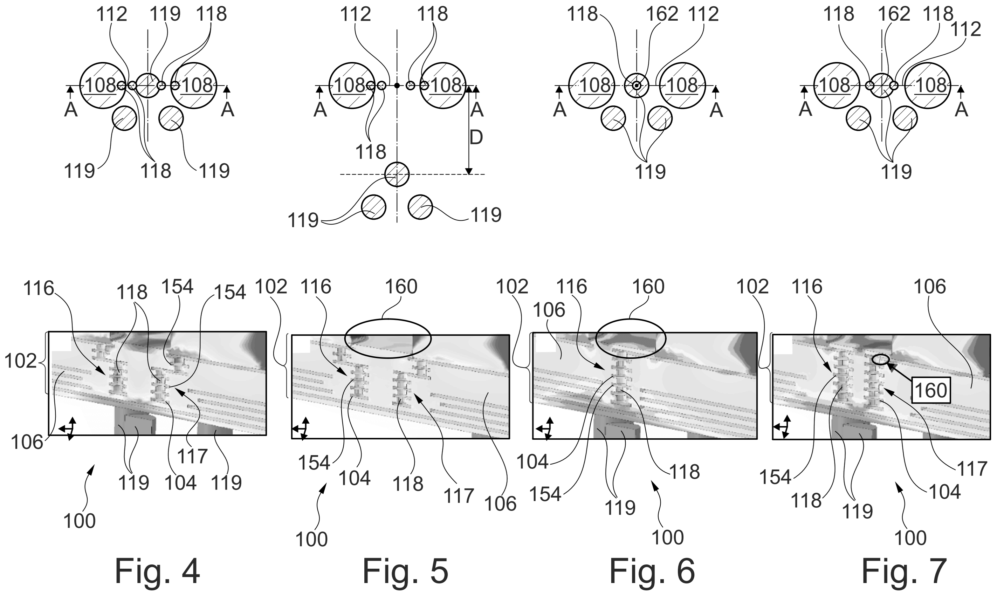

In an embodiment, a respective conductive through connection and at least one other of said stacked vertical connection elements, in particular a sub-portion of stacked vertical connection elements, overlap at least partially with each other in a viewing direction corresponding to a layer stack thickness direction. Figure 6 illustrates such an embodiment in which stacked vertical connection elements are even coaxial with a respective conductive through connections. The stress acting on the electrically external connecting element may be distributed through the respective conductive through connection and at least one vertical through connection and thus may be distributed within the core of the layer stack and the build-up structure.

In an embodiment, two internal stacks of stacked vertical connection elements are connected to or encompass a common conductive through connection. Such a common conductive through connection may extend vertically through a core of the layer stack and may be electrically coupled with a stack of vertical connection elements in a build-up on such a core. Such a configuration may distribute the stress created by the conductive through connection on at least two stacked vertical connection elements.

In an embodiment, one internal stack overlaps, in particular along the virtual connection axis, and/or is coaxially centered with the conductive through connection in a viewing direction corresponding to a layer stack thickness direction. An overlapping embodiment is shown for example in Figure 3, whereas a coaxial embodiment is illustrated in Figure 6.

In an embodiment, the other internal stack overlaps, in particular along the virtual connection axis, and/or is coaxially centered with the conductive through connection in the viewing direction corresponding to a layer stack thickness direction. Also this is shown in Figure 3 and Figure 6, respectively.

In an embodiment, the other internal stack does not overlap and/or is not coaxially centered with the conductive through connection in the viewing direction corresponding to a layer stack thickness direction. This option offers a further design parameter for reducing stress to thereby suppress the tendency of crack formation of the component carrier counter-acting the stress caused by the respective conductive through connection.

In an embodiment, the internal stacks are symmetric with respect to a vertical plane encompassing the virtual connection axis between the pair of external connecting elements. Such a symmetric internal stack configuration may suppress undesired phenomena such as warpage and delamination.

In an embodiment, the internal stacks extend at least partially through a core of the layer stack and/or extend at least partially through one or two build-up structures on opposing sides of a core of the layer stack. However, other exemplary embodiments may also apply to coreless substrates.

In an embodiment, the internal stacks are shifted in a horizontal plane at one or both of said build-up structures. In particular, stress reduction by shifting for suppressing the tendency of crack formation may be carried out on both opposing main surfaces of the layer stack, so that the counter actions for the stress released through the positioning the stacked vertical connection elements according to one or more or all the embodiments mentioned above can be also provided between the two opposed build-up structures.

In an embodiment, at least one of the stacked vertical connection elements in one build-up structure is shifted in a horizontal plane away from the virtual connection axis with respect to other ones of the stacked vertical connection elements on the opposing build-up structure. Hence, also a mutual shift of stacked vertical connection elements in opposing build-ups on a core may be used as a degree of freedom for stress reduction.

In an embodiment, the at least one shifted of the stacked vertical connection elements is horizontally shifted away from the virtual connection axis by a distance of at least 500 µm, in particular of at least 1000 µm. Simulations have shown that such a large shift has a very pronounced impact on stress reduction (compare in particular Figure 13 to Figure 15).

In an embodiment, the component carrier is configured as integrated circuit substrate. In particular for an IC substrate, and more particularly at an interface of an IC substrate to an electronic board, stress reduction for avoidance of cracks may be of utmost importance, because this has turned out to be a specifically critical region.

In an embodiment, the external connecting elements are solder structures, in particular solder balls. An interface between solder bumps and an electrically conductive exterior surface of a layer structure may be particularly prone to cracks in the event of excessive stress. Thus, stress reduction by mutual shifting of stacked vertical connection elements with respect to external connecting elements may be highly advantageously in the described context.

In an embodiment, the vertical connection elements comprise metallized laser vias and/or mechanically drilled metal-plated conductive through connections. For instance, the vertical connection elements may be formed by drilling laser holes (which may have a frustoconical shape) in an electrically insulating layer structure of the layer stack and filling the holes with a metal, such as copper. This may be done by plating, for instance electroless plating followed by electroplating. Conductive through connections may be formed by mechanically drilling holes (which may have a cylindrical shape) in an electrically insulating layer structure, in particular using a rotating drill bit. Such holes may be filled with the metal, for instance copper. Said metal filling may be accomplished for example by plating and/or by dispensing electrically conductive paste.

In an embodiment, the method comprises simulating stress exerted to the component carrier at an interface of the component carrier to a mounting board. Specifically such an interface may be sensitive concerning cracks, so that a focus on the simulation on this region may be beneficial.

In an embodiment, the method comprises designing and manufacturing a component carrier having the above mentioned features. In particular, the virtually modifying of the method may comprise horizontally shifting at least one of the stacked vertical connection elements of a respective one of the at least one internal stack away from a virtual connection axis passing through centers of a pair of adjacent external connecting elements. A result of the component carrier design method may be any of the above-described geometrical measures for reducing stress, or any of their geometries shown in the figures.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. In particular a naked die as example for an electronic component can be surface mounted on a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). A printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In an embodiment, the component carrier is an integrated circuit substrate. In the context of the present application, the term "integrated circuit substrate" (IC substrate) may particularly denote a component carrier having a size and a pitch adjusted to the requirements of an integrated circuit component (in particular a semiconductor chip) mounted thereon. An IC substrate may be a, in relation to a PCB, comparably small component carrier onto which one or more integrated circuit components may be mounted and that may act as a connection body between one or more chip(s) and a PCB or being plugged in a socket mounted on a PCB. For instance, an IC substrate may have substantially the same size as an electronic component to be mounted thereon (for instance in case of a Chip Scale Package (CSP)). In another embodiment, the IC substrate may be larger than the assigned component (for instance in a flip chip ball grid array, FCBGA, configuration). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the IC substrate and can be used to provide electrical, thermal and/or mechanical connections of housed components or unhoused components (such as bare dies), particularly of IC chips, with a printed circuit board or interposer. A dielectric part of an IC substrate may be composed of resin with reinforcing particles (such as reinforcing spheres, in particular glass spheres). A pitch, i.e. a distance between corresponding edges of two adjacent metal structures, of an IC substrate may be not more than 150 µm, in particular not more than 100 µm. In contrast to this, a pitch of some kind of PCBs may be at least 200 µm, in particular at least 300 µm.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, Melamine derivates, Polybenzoxabenzole (PBO), bismaleimide-triazine resin, polyphenylene derivate (for example based on polyphenylenether, PPE), polyimide (PI), polyamide (PA), liquid crystal polymer (LCP), polytetrafluoroethylene (PTFE), Bisbenzocyclobutene (BCB) and/or a combination thereof. Reinforcing layer structures such as webs, fibers, spheres or other kinds of filler particles, for example made of glass (multilayer glass) in order to form a composite, could be used as well. A semi-cured resin in combination with a reinforcing agent, for example fibers impregnated with the above-mentioned resins is called prepreg. These prepregs are often named after their properties for example FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, titanium, molybdenum and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one electronic component may be surface mounted on and/or embedded in the layer stack. The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs), indium phosphide (InP), and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be surface mounted on the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.
Figure 1 illustrates a three-dimensional view and an image of part of a component carrier according to an exemplary embodiment of the invention.
Figure 2 illustrates a plan view of part of a component carrier according to an exemplary embodiment of the invention.
Figure 3 illustrates a cross-sectional view of part of a component carrier according to an exemplary embodiment of the invention.
Figure 4 illustrates a plan view and a three-dimensional view of part of a component carrier according to an exemplary embodiment of the invention.
Figure 5 illustrates a plan view and a three-dimensional view of part of a component carrier according to an exemplary embodiment of the invention.
Figure 6 illustrates a plan view and a three-dimensional view of part of a component carrier according to an exemplary embodiment of the invention.
Figure 7 illustrates a plan view and a three-dimensional view of part of a component carrier according to an exemplary embodiment of the invention.
Figure 8 illustrates a plan view of part of a component carrier according to an exemplary embodiment of the invention.
Figure 9 illustrates a plan view of part of a component carrier according to an exemplary embodiment of the invention.
Figure 10 illustrates a plan view of part of a component carrier according to an exemplary embodiment of the invention.
Figure 11 illustrates a plan view of part of a component carrier according to an exemplary embodiment of the invention.
Figure 12 illustrates a plan view of part of a component carrier according to an exemplary embodiment of the invention.
Figure 13 illustrates a plan view of part of a component carrier according to an exemplary embodiment of the invention.
Figure 14 illustrates a plan view of part of a component carrier according to an exemplary embodiment of the invention.
Figure 15 illustrates a plan view of part of a component carrier according to an exemplary embodiment of the invention.
Figure 16 illustrates a plan view of part of a component carrier according to an exemplary embodiment of the invention.
Figure 17 illustrates a plan view of part of a component carrier according to an exemplary embodiment of the invention.
Figure 18 illustrates a plan view of part of a component carrier according to an exemplary embodiment of the invention.
Figure 19 illustrates a plan view of part of a component carrier according to an exemplary embodiment of the invention.
Figure 20 illustrates a plan view of part of a component carrier according to an exemplary embodiment of the invention.
Figure 21 illustrates cross-sectional views of parts of a component carrier according to an exemplary embodiment of the invention.
Figure 22 illustrates a flowchart showing a method of designing and manufacturing a component carrier according to an exemplary embodiment of the invention.

The illustrations in the drawings are schematic. In different drawings, similar or identical elements are provided with the same reference signs.

In component carrier and module applications, a main driver for warpage is usually the high amount of components on top or bottom of the PCB. Especially for single side assembled PCBs the risk of warpage is quite high. By utilizing an appropriate core thickness, the risk of warpage can be reduced.

However, cracking issues may occur in particular in dielectric layers of component carriers. More specifically, at an interface between a solder resist and solder balls, crack issues may be particularly pronounced.

According to an exemplary embodiment, a reliable component carrier, for example an integrated circuit substrate, having a layer stack of metallic and organic layer structures may be provided. A plurality of external electrically conductive connecting elements distanced with respect to each other in a horizontal plane along a virtual connection axis may be formed at a main surface of the layer stack, for example solder structures. Vertical connection elements, such as plated through holes and/or laser vias, stacked inside the layer stack and electrically coupled with one or more of said external connecting elements may be horizontally displaced away from a virtual connection axis between external connecting elements. As indicated by simulation results carried out by the present inventors, design parameters related to such shifting can reduce stress inside of the component carrier, which may efficiently improve crack resistance and suppress warpage, delamination, etc. This may render the component carrier more reliable without adding significant manufacturing effort. After designing a component carrier in accordance with stress simulation results, said component carrier may be manufactured accordingly. It has also turned out as beneficial to consider also a mutual shift between the above-mentioned shifted vertical connection element and one or more other of stacked vertical connection elements, since this additional design parameter may allow to additionally reduce stress.

Accordingly, a component carrier design and manufacturing method may be provided according to an exemplary embodiment of the invention. The component carrier to be designed and manufactured may be defined in terms of specifying characteristics of layer stack, external connecting elements, stacked vertical connection elements, etc. On the basis of this specification, position, shape and/or dimensions of layer stack, external connecting elements, stacked vertical connection elements, etc. may be parameterized, and initial parameter values may be defined or determined, for instance in accordance with a specific application of the component carrier to be designed and manufactured. Stress acting on the component carrier during manufacture, electric operation and/or in the presence of thermal load may then be simulated, for instance using a numerical model for obtaining information about the behavior of the component carrier with this parameterization. In particular, a finite element method may be used for simulation. The initial parameterization may then be changed taking into account simulation results. When an additional simulation shows that the modified parameterization leads to the same or even larger stress, it may be rejected, and another modification may be tried. When an additional simulation shows that the modified parameterization reduces stress, it may be accepted, and may be optionally further refined to further reduce stress. When a simulation result, obtained after one or more iterations, indicates compliance with a predefined specification or meets another acceptance criterion, the virtually developed component carrier may be physically manufactured accordingly. Beneficially, this may allow to obtain a component carrier with low manufacturing effort and high reliability.

In an embodiment, design improvement of a component carrier can be easily implemented to obtain better reliability on assembly level. In particular, an advanced laser via stack design may be provided to improve crack resistance of dielectrics of component carriers, such as assembled IC substrates. Preferably, a side of an IC substrate with coarser structures facing a motherboard and facing away from a surface mounted electronic component in an assembled condition may be the main surface with the external connecting elements to be simulated and improved according to exemplary embodiments. To achieve such advantages, it may be possible to carry out simulations to improve the component carrier design and reduce stress. Different configurations can be tested virtually and several factors were found concerning design and mutual arrangement of stacked vertical connection elements with respect to external connecting elements. In particular, improvements concerning design may relate to an out-of-plane via path which may be adapted to reduce stress and prevent cracking.

In particular when using laser vias under a Ball Grid Array (BGA) or Land Grid Array (LGA), tests of assembled IC substrates during a thermal shock/cycle test (TST/TCT) indicated that cracks can occur in the dielectric. In view of this, special design changes related to the out-of-plane path of plated through holes or metallized laser vias can reduce the stress in the dielectric and thus the risk of cracking. A gist of an exemplary embodiment is to place a corresponding laser in a stress-reduced position between a BGA/LGA and a plated through hole (PTH) manufactured inside a core of the component carrier. For this purpose, finite element simulations have been carried out confirming that significant advantages can be achieved.

According to an exemplary embodiment, the location of stack internal vertical connection elements, in particular with respect to external connecting elements at a main surface of the stack, may be changed to reduce stress of the component carrier, in particular in the build-up film(s) thereof. However, it is also been found that also the thickness of the various layers may have an impact on stress and may thus be modified in an embodiment of the method of designing and manufacturing a component carrier. For example, it has been found that a modification of a thickness of an electrically insulating layer structure may reduce stress. In particular, it has been found that an increase of the thickness of an Ajinomoto Build-up Film (ABF) of the layer stack from 25 µm to 32 µm can reduce stress by 9%.

In an embodiment, removing a plated through hole in comparison with an initial or reference design may reduce stress. Also removing one or more vias may lead to a stress reduction. For example, a significant stress reduction may require shifting a plated through hole sufficiently, for example at least by 1000 µm. Especially a middle plated through hole may have a high impact on stress reduction.

Design modifications obtained by carrying out a method according to an exemplary embodiment of the invention have also been re-calculated based on real design data and have proven to reduce stress by the means of finite element simulations. Corresponding physically manufactured component carriers show an excellent reliability in the real world.

In an embodiment, it may also be possible to modify a PCB center core thickness to reduce or even minimize warpage of asymmetric assembled modules. To ensure reliable PCBs, it may also be advantageous to adapt the core thickness to the amount of silicon mounted on the board. By using advanced finite element simulations, it may be possible to evaluate an advantageous or even optimum core thickness. Furthermore, reducing warpage of a component carrier may lead to more reliable component areas with improved performance and may also increase yield during thermal loading (for example occurring during a reflow process, etc.). In particular, one important design parameter to produce more reliable PCBs may be the adaption of the core thickness. In an embodiment, an exemplary embodiment provides a laser via stack to improve crack resistance of dielectrics of assembled IC substrates. In substrate design, the via and/or plated through hole location may have a significant influence on package reliability (for example concerning avoidance of cracks). When modifying one or more design parameters according to exemplary embodiments, it may be advantageous to do this under consideration of boundaries to meet electrical requirements of the component carrier to be designed and manufactured.

According to exemplary embodiments, one or more of the following measures may be taken for improving crack resistance, suppressing warpage and/or avoiding delamination: It may be possible to change the location of vias and/or plated through holes to reduce the stress in a build-up film. It may be possible to change the design according to simulation findings to reduce stress in the outer build-up layer of an IC substrate. In such a layer, a risk for cracks in a component carrier may be particularly pronounced. Furthermore, it may be possible to reduce stress in the build-up film layer and thus decrease the probability for reliability issues. Additionally, by adapting the design with small changes it may be possible to meet one or more predefined electrical performance requirements (such as impedance, signal integrity, losses). Advantageously, the improvement of reliability of component carriers according to exemplary embodiments of the invention can be achieved with low effort.

According to an exemplary embodiment of the invention, a component carrier may be provided which comprises a stack comprising at least one electrically conductive layer structure and at least one insulating layer structure, a plurality of external connecting elements (for example solder balls, solder structures) on one of the main surfaces of the stack, wherein each couple of adjacent ones of said plurality of external connecting elements are divided, from a top view, by a space extending along a distancing axis passing through the center of both adjacent external connecting elements, at least a stack of vertical connections extending internally the stack and directly connected to a conductive surface in contact with the respective one of said external connecting elements, wherein at least one of the stacked vertical connections is planarly shifted away from the distancing axis with respect to the other ones (preferably distanced towards a distancing direction; a plurality of vertical connection may be distanced from the majority ones of the stacked vertical connections, toward the same distancing direction, toward a different distancing direction; a plurality may be distanced towards a first distancing direction and at least one or a plurality towards a second distancing direction) of the stacked vertical connections.

In an embodiment, a plurality of the stacked vertical connections overlap, in particular are aligned with, the distancing axis. Said plurality of the stacked vertical connections may be a majority, in particular more than 50%, of the stacked vertical connections. In an embodiment, those may be the closer or the ones closer, along the stack thickness direction, from the external connecting elements. In an embodiment, the conductive layer structure may connect the shifted stacked vertical connections. For instance, some of the stacked vertical connections are overlapped with each other and others are shifted and overlapped with each other. In an embodiment, the shifted vertical connections are in the layer structure of the stack away from the peripheral ones. For example, the shifted vertical connections may be in the internal portion, layers or structures of the stack. In particular, the stacked vertical connections may comprise vias. For instance, each one of the couple of adjacent of said plurality of external connecting elements are connected to a respective stacked vertical connection. In an embodiment, stacked vertical connections may be connected with each other through at least one electrically conductive layer structure. For instance, the vertical connections closer to the respective connecting element may be closer to the center of said connecting element. For example, the vertical connections closer to the respective connecting element overlap (preferably fully overlap), in a planar view, with the planar extension of the connecting element. In an embodiment, the vertical connections defining the peripheral first or the first two stacked sub-portions are vertically aligned (for example coaxially, planarly overlapping one to each other; in particular, at least 80% of the surfaces may overlap with each other) with a respective connecting element in the stack. For instance, the vertical connections defining a plurality of stacked sub-portions, in particular the more peripheral two sub-portions, overlap (in particular in a planar view) with the connecting element. In an embodiment, at least one of the central layer of the stack comprises a conductive through connection (in particular a plated through connection) passing the layer, said conductive through connection belonging or being connected to the stacked vertical connections. For example, a conductive through connection may have a larger planar extension (in particular a larger diameter) than the vertical connections. In particular, a conductive through connection may be smaller than the respective (in particular that one being connected with the stacked vertical connection where the plated conductive through connection belongs to or is connected) connecting element. For instance, said conductive through connection may be planarly shifted with respect to the distancing axis. This may be done in an overlapping manner, in particular centered with the distancing axis. For example, the conductive through connection and at least one respective vertical connection, in particular a stacked sub portion of vertical connections, may overlap, at least partially, with each other. In an embodiment, at least two branches of vertical connections are connected to a common conductive through connection. For instance, one branch may overlap, in particular along the distancing axis and/or centered with, the conductive through connection. The other may or may not overlap. In an embodiment, there may be a planar symmetry of the branches along the vertical plane perpendicular to the vertical plane passing through the center of the couple of connecting elements. In an embodiment, the central layer of the stack may comprise a core. For instance, build-up structures may be formed on both opposing main surfaces of the central layer. In an embodiment, there may be a planar shifting on one or both of the build-up structures. For example, at least one of the stacked vertical connections in one build-up structure may be planarly shifted away from the distancing axis with respect to other ones. Preferably, this may lead to a distancing towards a distancing direction. For example, a plurality of vertical connections are distanced from majority ones of the stacked vertical connections, in particular toward the same distancing direction, or toward different distancing directions. In particular, one or a plurality of said stacked vertical connections on the opposing build-up structures may be shifted towards a first distancing direction, and one or a plurality of said stacked vertical connections on the opposing build-up structures may be shifted towards a second distancing direction.

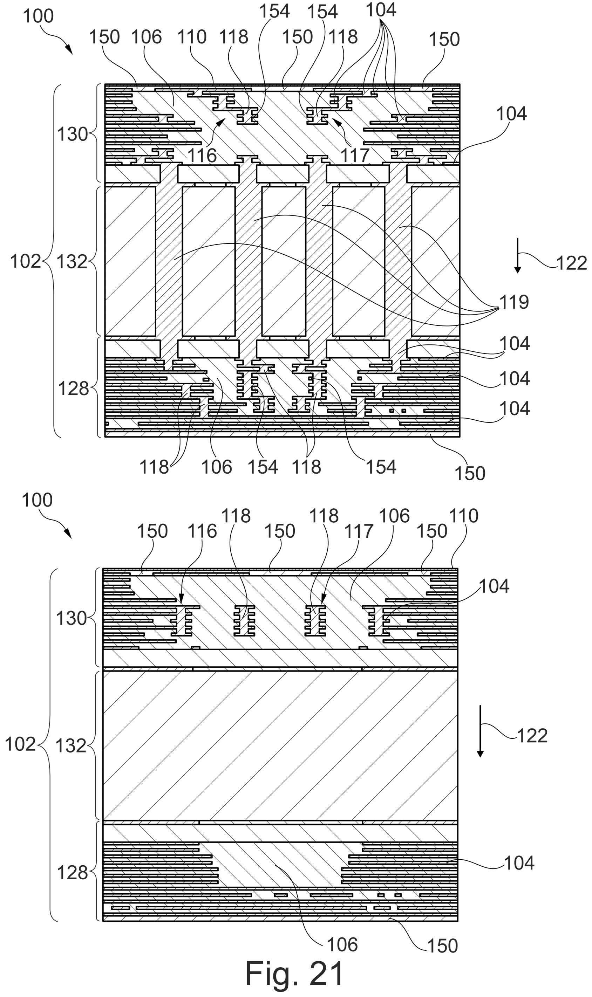

**Figure 1** illustrates a three-dimensional view of and an image of part of a component carrier 100 according to an exemplary embodiment of the invention. The scale on the right-hand side of Figure 1 illustrates stress levels in different regions of the component carrier 100, as obtained by a simulation. **Figure 2** illustrates a schematic plan view of part of component carrier 100, as well as a detail 156. **Figure 3** illustrates a cross-sectional view, along a line A-A of Figure 2, of part of component carrier 100. The component carrier 100, which may be an integrated circuit (IC) substrate, may be connected at one interface to a mounting board 190 (for instance a motherboard) and may be connected at an opposing interface 192 to an electronic component (such as a surface mounted semiconductor die, not shown). Between said interface 192 and the electronic component, a further build-up may be arranged (not shown in Figure 3, see reference sign 128 in Figure 21). In particular the interface region between mounting board 190 and component carrier 100 may be prone to cracks or other undesired phenomena influencing reliability of the component carrier 100.

The component carrier 100 may comprise a laminated layer stack 102 comprising electrically conductive layer structures 104 and electrically insulating layer structures 106. For example, the electrically conductive layer structures 104 may comprise patterned metal layers (such as patterned copper foils or patterned deposited copper layers) and vertical through connections, for example copper filled vias, which may be created by drilling and plating. The electrically insulating layer structures 106 may comprise a respective resin (such as a respective epoxy resin), preferably comprising reinforcing particles therein (for instance glass fibers or glass spheres). For example, the electrically insulating layer structures 106 may be made of prepreg or FR4. The electrically insulating layer structures 106 may also comprise resin layers being free of glass (in particular free of glass fibers).

Furthermore, Figure 1 to Figure 3 illustrates that a plurality of electrically conductive external connecting elements 108 are provided on main surface 110 of the layer stack 102. In the shown embodiment, the electrically conductive external connecting elements 108 may be solder bumps. Such solder bumps may be used for establishing a solder connection between the component carrier 100 and an electronic periphery, such as mounting board 190 to be connected with the stack 102 at main surface 110. Alternatively, main surface 110 may be connected with one or more surface mounted components, such as semiconductor chips (not shown).

At main surface 110, an electrically insulating patterned layer of solder resist 150 may be formed. Solder resist 150 may define regions of main surface 110 which shall be kept free of solder material. Furthermore, solder resist 150 may protect main surface 110, in particular against undesired oxidation. It has been found that in particular an interface region, indicated by an arrow 152 in Figure 1, between solder resist 150 and external connecting elements 108 may be prone to failure. In particular, cracks may occur in such an interface region 152. However, also other regions of component carrier 100 may be prone to cracks. Other undesired phenomena in a component carrier 100 may be warpage and delamination. Exemplary embodiments of the invention may relate to the design and manufacture of a component carrier 100 so that such undesired phenomena, in particular the occurrence of cracks, may be strongly suppressed or even fully eliminated.

As best seen in Figure 2, the illustrated pair of adjacent ones of said plurality of external connecting elements 108 are horizontally separated or spaced with respect to each other by a spacing L extending along a straight virtual connection axis 112 connecting and passing through centers 114 (which may be centers of gravity) of both adjacent external connecting elements 108 of said pair. For example, said spacing L may be in a range from 50 µm to 5 mm. Although not shown, there may be further external connecting elements 108 and therefore also further pairs of external connecting elements 108.

As can be taken in particular from Figure 1 and Figure 3, two internal stacks 116-117 of stacked vertical connection elements 118 extend internally of the layer stack 102. In other embodiments, it is also possible that only one internal stack or at least three internal stacks are present. All external connecting elements 108 may be connected to a respective group of stacked vertical connection element 118-119, see Figure 3. As shown in Figure 3, the internal stacks 116-117 may be symmetric with respect to a vertical plane, i.e. the paper plane of Figure 3, encompassing the virtual connection axis 112 between the pair of external connecting elements 108 and encompassing a layer stack thickness direction 122, which may be a vertical direction.

As shown, stacked vertical connection elements 118-119 may comprise stacked metallized laser vias 118 with pads 154 in between. In particular, an alternating sequence of at least two metallized laser vias 118 and at least two pads 154 may be foreseen. Metallized laser vias 118 may be frustoconical or cylindrical metal structures. Pads 154 may be flat or planar, for instance circular, portions of a patterned metal layer, for instance of a deposited copper layer or an attached copper foil. Moreover, stacked vertical connection elements 118-119 may also comprise one or more conductive through connections 119, for instance plated through holes. Conductive through connections 119 may also be stacked with metallized laser vias 118, and pads 154, wherein also electrically conductive layer structures 104 with large planar extension may be connected. Consequently, the metallized laser vias 118 of an internal stack 116-117 are connected with each other through pads 154 of different electrically conductive layer structures 104. Conductive through connections 119 may for instance be cylindrical structures filled with a metal such as copper. For instance, conductive through connections 119 may be formed by mechanically drilling stack 102 or parts thereof, followed by a metallic plating process or dispensing of electrically conductive paste for filling said mechanically drilled through holes. For example, plating may comprise electroless plating, in particular for forming a seed layer, and/or electroplating, for instance galvanic plating. A diameter of a conductive through connection 119 may be larger than a diameter of a metallized laser via 118. For example, the diameter of a conductive through connection 119 may be in the range from 150 µm to 300 µm, whereas the diameter of a metallized laser via 118 may be in the range from 30 µm to 150 µm.

As best seen in Figure 3, a central layer of the layer stack 102 in form of an electrically insulating fully cured core 132 (for instance made of FR4 material) comprises the conductive through connections 119 (one is visible in Figure 3, three are visible in Figure 1) passing through this central layer. These conductive through connections 119, embodied as plated through holes, belong to the stacked vertical connection elements 118-119. As shown in Figure 3, at least part of the internal stacks 116-117 may be arranged in build-up structure 130 on top of core 132.

Referring to Figure 3, the two internal stacks 116-117 of stacked vertical connection elements 118-119 are connected with each other by and encompass a common conductive through connection 119. As can be taken from Figure 2 and Figure 3, stacked metallized laser vias 118 of each of said internal stacks 116-117 (at least partially) overlap along the virtual connection axis 112 with said common conductive through connection 119 in a viewing direction corresponding to a layer stack thickness direction 122. Alternatively, such an overlapping may be present only for one of said internal stacks 116-117, not for the other one (not shown in Figure 1 to Figure 3). The stacked vertical connection elements 118-119 in the shown embodiment may be directly connected to an electrically conductive exterior surface 126 of the layer stack 102 being in contact with a respective one of said external connecting elements 108. The electrically conductive exterior surface 126 may be a metallic pad exposed at main surface 110 for connection with said external connecting elements 108. For instance, the electrically conductive exterior surface 126 may comprise a surface finish (such as ENIG) at its exterior exposed area. Such a surface finish may promote solderability of solder-type external connecting elements 108 on electrically conductive exterior surface 126. For instance, an uninterrupted electrically conductive path may be established by conductive through connections 119, metallized laser vias 118, pads 154, electrically conductive exterior surface 126 and external connecting elements 108.

Now referring specifically to detail 156 in Figure 2, a cross-sectional area A of a respective conductive through connection 119, embodied as plated through hole, in a horizontal plane may be larger than a cross-sectional area a of each conductive through connection 118, embodied as metallized laser via, in the horizontal plane. Moreover, said cross-sectional area A of a respective conductive through connection 119, embodied as plated through hole, may be smaller in the horizontal plane than a cross-sectional area H of each respective external connecting element 108.

Still referring in particular to Figure 2, some of the stacked vertical connection elements 118-119 of the internal stacks 116-117 may be horizontally shifted away from the virtual connection axis 112 with respect to other of the stacked vertical connection elements 118-119 of said internal stack 116-117. In the embodiment of Figure 2, the shifted vertically connection elements 118-119 are two conductive through connections 119. More specifically, while all metallized laser vias 118 and one conductive through connection 119 may lie on virtual connection axis 112 in the illustrated plan view, two other conductive through connections 119 are displaced or shifted away in the horizontal plane (corresponding to the paper plane of Figure 2) from virtual connection axis 112. In other words, two conductive through connections 119 are horizontally shifted away from the virtual connection axis 112. According to Figure 2, the one non-shifted conductive through connection 119 is centered at the virtual connection axis 112 in a viewing direction corresponding to the layer stack thickness direction 122. As also shown in Figure 2, the latter mentioned conductive through connection 119 and the horizontally innermost metallized laser vias 118 of said stacked vertical connection elements 118-119 overlap partially with each other in the viewing direction corresponding to layer stack thickness direction 122. Simulations show that such a shift or displacement may lead to a reduction of stress and therefore crack risk of component carrier 100, in particular in interface region 152.

According to Figure 2, a majority of the stacked vertical connection elements 118-119 overlap and are even aligned with the virtual connection axis 112. This holds for all metallized laser vias 118 and the one conductive through connection 119 between them in the plan view of Figure 2. In particular, a sub-set of the stacked vertical connection elements 118-119, i.e. the vertically and laterally outermost metallized laser vias 118, located closer to the external connecting elements 108 in a viewing direction corresponding to a layer stack thickness direction 122 than another sub-set of the stacked vertical connection elements 118-119 overlap and are aligned with the virtual connection axis 112. The viewing direction corresponding to the layer stack thickness direction 122 is vertically according to Figure 1 to Figure 3 and perpendicular to the paper plane of Figure 2. As shown in Figure 3, the uppermost electrically conductive layer structure 104 constituting also electrically conductive exterior surface 126, may electrically connect some or all of the shifted stacked vertical connection elements 118-119. Referring to Figure 2, another sub-set of said stacked vertical connection elements 118-119, i.e. the innermost metallized laser vias 118 and the conductive through connection 119 on virtual connection axis 112, overlap each other in the viewing direction corresponding to the layer stack thickness direction 122. However, said other sub-set of said stacked vertical connection elements 118-119 is not horizontally shifted away from the virtual connection axis 112. The two shifted conductive through connections 119 of the stacked vertical connection elements 118-119, see Figure 2, are arranged more centrally in layer stack thickness direction 122 than all metallized laser vias 118 being non-shifted and being arranged more peripherally in layer stack thickness direction 122, compare Figure 1. As can be taken from Figure 1 to Figure 3, the upper metallized laser vias 118 of said vertical connection elements 118-119 located vertically closer to a neighbored external connecting element 108 than lower metallized laser vias 118 are located horizontally closer to a center 114 of said external connecting element 108 in a viewing direction corresponding to layer stack thickness direction 122 than lower metallized laser vias 118 of said vertical connection elements 118-119 located vertically further away from said external connecting element 108. As can be taken from Figure 2, said upper metallized laser vias 118 of said vertical connection elements 118-119 located closer fully overlap in the viewing direction corresponding to the layer stack thickness direction 122 with the horizontal extension of said neighbored external connecting element 108. More specifically, said upper metallized laser vias 118 of the stacked vertical connection elements 118-119 and the neighbored external connecting element 108 overlap with each other with an overlapping surface being 100% of the area of the respective upper metallized laser via 118 in the viewing direction corresponding to the layer stack thickness direction 122. The described overlapping is present in both said internal stacks 116-117.

Moreover, the stacked vertical connection elements 118-119 may also be staggered due to manufacturing tolerances. Thus, the staggered alignment of the stacked vertical connection elements 118-119 may not have a big impact on stress distribution compared to the stacked vertical connection elements 118-119.

Simulations have shown that with the structure according to Figure 1 to Figure 3, in particular as a consequence of said shifting, stress in the component carrier 100 may be sufficiently small to achieve good crack resistance. However, even this embodiment can be further improved, as described below.

During a reliability test, cracks may be detected in the dielectric material of a stack 102 of a component carrier 100. Based on this data, design features may be identified that are considered to cause a certain stress state that leads to cracking in a certain thermal-mechanical load condition. To obtain such information, simulations have been carried out using a finite element method. In the framework of such a simulation, a simplifying physical model may be created to evaluate the highly complex structure. It may then be checked whether the simulated stress shows maxima in similar areas to a failure location of physical samples. Furthermore, different design options may be checked to reduce or even minimize the stress in this area and provide design rules for a further improvement. Such a simulation may be based on design and material parameters. Calculated stress data can be interpreted to propose design modifications for reducing stress. On this basis, the exemplary component carrier design according to Figure 1 to Figure 3 has been found, and has even been further improved by the below described embodiments.

Next, further options of reducing stress according to exemplary embodiments of the invention are explained:
**Figure 4** illustrates a plan view and a three-dimensional view of part of a component carrier 100 according to an exemplary embodiment of the invention. Figure 4 illustrates again the scenario according to Figure 1 to Figure 3, which can be considered as a reference for further modifications according to the subsequently discussed figures and embodiments. The scale in Figure 4, as in the subsequent figures, illustrates stress levels in different regions of the component carrier 100, as obtained by a simulation.

**Figure 5** illustrates a plan view and a three-dimensional view of part of a component carrier 100 according to an exemplary embodiment of the invention. The embodiment of Figure 5 differs from the embodiment of Figure 4 in particular in that, according to Figure 5, all conductive through connections 119 (which may be embodied as plated through holes) are shifted or displaced within the horizontal plane according to main surface 110 of stack 102 away from the virtual connection axis 112 connecting a pair of external connecting elements 108. All metallized laser vias 118 remain on the virtual connection axis 112 in a viewing direction corresponding to the layer stack thickness direction 122. According to Figure 5, each of the shifted ones of the stacked vertical connection elements 118-119 is horizontally shifted away from the virtual connection axis 112 by a distance D of at least 500 µm, for example by 1000 µm. With a shift of 1000 µm, simulations confirm a further stress reduction of 22% over the embodiment of Figure 4, in particular in a stress critical region 160.

**Figure 6** illustrates a plan view and a three-dimensional view of part of a component carrier 100 according to an exemplary embodiment of the invention. The embodiment of Figure 6 differs from the embodiment of Figure 4 in particular in that, according to Figure 6, all metallized laser vias 118 are located at the same position on the virtual connection axis 112 in a viewing direction corresponding to the layer stack thickness direction 122. They are all located more specifically at a center position 162 in the middle between the centers 114 of the external connecting elements 108. Centers of the metallized laser vias 118 are also coaxial with a center of the conductive through connection 119 lying on virtual connection axis 112. The embodiment of Figure 6 may be denoted as a stack of central coaxial vias. Simulations confirm a further stress reduction of 26% over the embodiment of Figure 4, in particular in a stress critical region 160.

**Figure 7** illustrates a plan view and a three-dimensional view of part of a component carrier 100 according to an exemplary embodiment of the invention. The embodiment of Figure 7 differs from the embodiment of Figure 6 in particular in that, according to Figure 7, all metallized laser vias 118 are located on the virtual connection axis 112 in a viewing direction corresponding to the layer stack thickness direction 122 but are located in two separate groups according to different internal stacks 116-117. The different groups of metallized laser vias 118 are mutually spaced along the virtual connection axis 112 symmetrically with respect to a center position 162 in the middle between the centers 114 of the external connecting elements 108. A first group of metallized laser vias 118 according to internal stack 116 are arranged on top of each other so as to be coaxially aligned. A second group of metallized laser vias 118 according to internal stack 117 are arranged on top of each other coaxially aligned with each other. Centers of metallized laser vias 118 of the first group and centers of metallized laser vias 118 of the second group may lie on a radius of the conductive through connection 119 with which both groups overlap on the virtual connection axis 112. The embodiment of Figure 7 may be denoted as stacks of vias side-by-side. Simulations confirm a further stress reduction of 24% over the embodiment of Figure 4, in particular in a stress critical region 160.

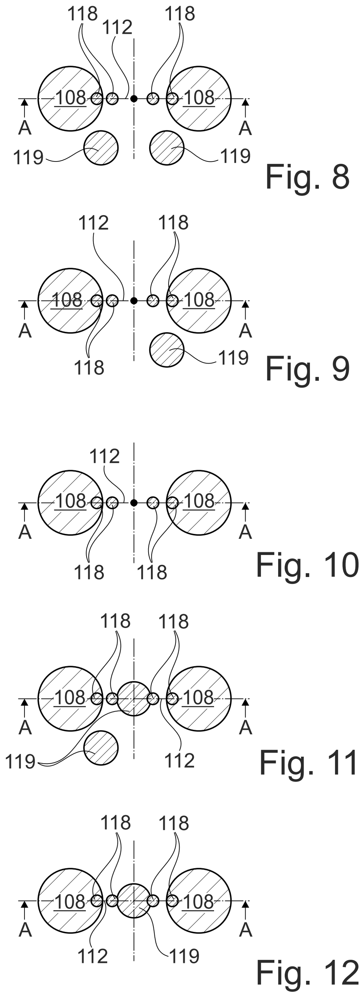

**Figure 8** illustrates a plan view of part of a component carrier 100 according to an exemplary embodiment of the invention. The embodiment of Figure 8 differs from the embodiment of Figure 4 in particular in that, according to Figure 8, the conductive through connection 119 on the virtual connection axis 112 is omitted. Simulations confirm a further stress reduction of 20% over the embodiment of Figure 4.

**Figure 9** illustrates a plan view of part of a component carrier 100 according to an exemplary embodiment of the invention. The embodiment of Figure 9 differs from the embodiment of Figure 8 in particular in that, according to Figure 9, one of the conductive through connections 119 shifted away from the virtual connection axis 112 is omitted. Simulations confirm a further stress reduction of 24% over the embodiment of Figure 4.

**Figure 10** illustrates a plan view of part of a component carrier 100 according to an exemplary embodiment of the invention. The embodiment of Figure 10 differs from the embodiment of Figure 4 in particular in that, according to Figure 10, all conductive through connections 119 are omitted. All metallized laser vias 118 lie on the virtual connection axis 112. Simulations confirm a further stress reduction of 24% over the embodiment of Figure 4. For example, conductive through connections 119 may be included in the stack 102 but may not be considered for the stress impact on external connecting elements 108, since they may be too far away.

**Figure 11** illustrates a plan view of part of a component carrier 100 according to an exemplary embodiment of the invention. The embodiment of Figure 11 differs from the embodiment of Figure 4 in particular in that, according to Figure 11, one of the conductive through connections 119 shifted away from the virtual connection axis 112 is omitted. Simulations confirm a further stress reduction of 7% over the embodiment of Figure 4.

**Figure 12** illustrates a plan view of part of a component carrier 100 according to an exemplary embodiment of the invention. The embodiment of Figure 12 differs from the embodiment of Figure 4 in particular in that, according to Figure 12, both conductive through connections 119 shifted away from the virtual connection axis 112 are omitted. Simulations confirm a further stress reduction of 9% over the embodiment of Figure 4.

**Figure 13** illustrates a plan view of part of a component carrier 100 according to an exemplary embodiment of the invention. The embodiment of Figure 13 corresponds to the embodiment of Figure 5, wherein the shift D1 in Figure 13 is 100 µm. Simulations confirm a further stress reduction of 6% over the embodiment of Figure 4.

**Figure 14** illustrates a plan view of part of a component carrier 100 according to an exemplary embodiment of the invention. The embodiment of Figure 14 corresponds to the embodiment of Figure 5, wherein the shift D2 in Figure 14 is 200 µm. Simulations confirm a further stress reduction of 12% over the embodiment of Figure 4.

**Figure 15** illustrates a plan view of part of a component carrier 100 according to an exemplary embodiment of the invention. The embodiment of Figure 15 corresponds to the embodiment of Figure 5, wherein the shift D3 in Figure 15 is 1000 µm. Simulations confirm a further stress reduction of 22% over the embodiment of Figure 4.

Thus, a sufficiently large shift D has a particularly advantageous impact on the stress reduction.

**Figure 16** illustrates a plan view of part of a component carrier 100 according to an exemplary embodiment of the invention. The embodiment of Figure 16 differs from the embodiment of Figure 4 in particular in that, according to Figure 16, the horizontally outermost metallized laser vias 118 are shifted with respect to the virtual connection axis 112 so that their centers are aligned and are coaxial with the centers 114 of the respective external connecting element 108. Hence, the metallized laser vias 118 of the stacked vertical connection elements 118-119 being located closest to a respective external connecting element 108 are coaxially aligned with said external connecting element 108 in layer stack thickness direction 122. The described alignment and coaxial arrangement is present in both corresponding internal stacks 116-117, wherein the left portion of Figure 16 relates to internal stack 116 and the right portion of Figure 16 relates to internal stack 117.

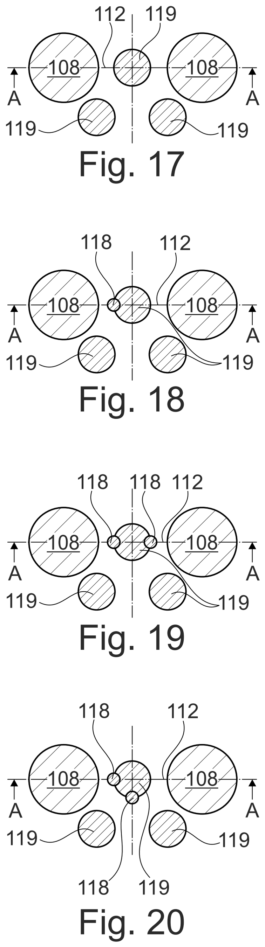

**Figure 17** illustrates a plan view of part of a component carrier 100 according to an exemplary embodiment of the invention. The embodiment of Figure 17 differs from the embodiment of Figure 4 in particular in that, according to Figure 17, all metallized laser vias 118 are omitted.

**Figure 18** illustrates a plan view of part of a component carrier 100 according to an exemplary embodiment of the invention. The embodiment of Figure 18 differs from the embodiment of Figure 4 in particular in that, according to Figure 18, a part of the metallized laser vias 118 of internal stack 116 are omitted and all metallized laser vias 118 of internal stack 117 are omitted.

**Figure 19** illustrates a plan view of part of a component carrier 100 according to an exemplary embodiment of the invention. The embodiment of Figure 19 differs from the embodiment of Figure 4 in particular in that, according to Figure 19, a part of the metallized laser vias 118 of internal stack 116 are omitted and a part of the metallized laser vias 118 of internal stack 117 are omitted.

**Figure 20** illustrates a plan view of part of a component carrier 100 according to an exemplary embodiment of the invention. The embodiment of Figure 20 differs from the embodiment of Figure 19 in particular in that, according to Figure 20, a part of the metallized laser vias 118 has been shifted away from virtual connection axis 112.

Simulations confirm a further stress reduction of 7-26% of the embodiments of Figure 17 to Figure 20 over the embodiment of Figure 4.

**Figure 21** illustrates cross-sectional views of parts of a component carrier 100 according to an exemplary embodiment of the invention.

Two different designs of the component carrier 100 are illustrated in Figure 21. In both designs, component carrier 100 comprises a core 132 (which may be a thick sheet of a fully cured dielectric material, such as FR4) on which build-up structures 128, 130 (such as laminated layer build-ups of electrically conductive layer structures 104 and electrically insulating layer structures 106) are formed. Said build-up structures 128, 130 may be arranged on opposing sides and main surfaces of core 132 of the layer stack 102.

For reducing stress in terms of crack resistance, it is for instance possible that at least one of the internal stacks 116-117 with its vertical connection elements 118-119 are shifted, in relation to each other and/or in relation to external connecting elements 108 (not shown in Figure 21) in a horizontal plane at one or both of said build-up structures 128, 130. For instance, it is possible that one or more of the stacked vertical connection elements 118-119 in one build-up structure 128, 130 are shifted in a horizontal plane away from a virtual connection axis 112 between adjacent external connecting elements 108 with respect to one or more other of the stacked vertical connection elements 118-119 on the opposing build-up structure 128, 130.

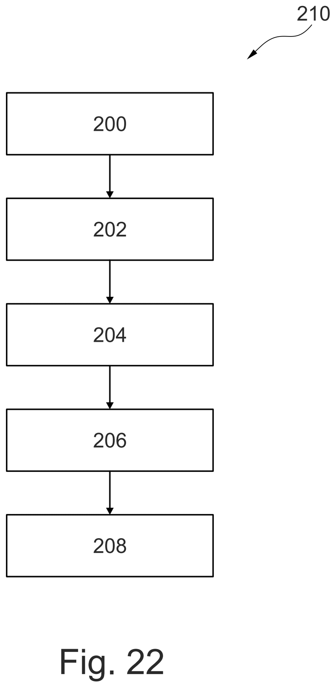

**Figure 22** illustrates a flowchart 210 showing a method of designing and manufacturing a component carrier 100 according to an exemplary embodiment of the invention.

As shown in a block 200, the method may comprise virtually specifying the component carrier 100 with a layer stack 102 which comprises at least one electrically conductive layer structure 104 and at least one electrically insulating layer structure 106, a plurality of electrically conductive external connecting elements 108 on and/or in one main surface 110 of the layer stack 102, and at least one internal stack 116-117 of stacked vertical connection elements 118-119, the internal stack 116-117 extending internally of the layer stack 102, the stacked vertical connection elements 118-119 being directly connected to an electrically conductive exterior surface 126 of the layer stack 102 in contact with a respective one of said external connecting elements 108. Thus, the general construction of the component carrier 100 may be defined theoretically, for instance in accordance with an application or a task to be fulfilled by the readily manufactured component carrier 200.

As shown in a block 202, the method may comprise parameterizing position, shape and/or dimensions of the electrically conductive external connecting elements 108, the stacked vertical connection elements 118-119, and/or the electrically conductive exterior surface 120. Also other elements of the component carrier 100 to be formed may be parameterized.

As shown in a block 204, the method may comprise simulating stress exerted to the virtually specified component carrier 100 based on the parameterized position, shape and/or dimensions. Such a simulation may for instance be carried out on the basis of a finite element method. Other numerical simulations are possible. The simulation may be carried out based on a model of the component carrier 100 to be designed. Stress may be simulated during electric operation of the component carrier 100, in the event of thermal load, during the manufacturing process, etc. In particular, stress exerted to the component carrier 100 at an interface of the component carrier 100 to a mounting board may be simulated. When the component carrier 100 to be developed and manufactured is an integrated circuit substrate, the physically manufactured component carrier 100 may be sandwiched between a mounting board (such as a printed circuit board) on one side and an electronic component (for example a semiconductor die) on the other side. In particular the design of an interface between mounting board and component carrier 100 may be of utmost importance for crack resistance. In other embodiments, the other interface may be analyzed additionally or alternatively in terms of stress. In yet other embodiments, another type of component carrier 100 may be developed and produced, for example a printed circuit board.

As shown in a block 206, the method may comprise virtually modifying, in accordance with a result of the simulating, the parameterized position, shape and/or dimensions for reducing simulated stress exerted to the virtually specified component carrier 100. In block 206, parameterization values specifying the component carrier 100 under development may be changed taking into account the results of the previous stress simulation. This modification may be made with a target of stress reduction as may be indicated by a repeated simulation with a modified parameterization. In this context, parameter values such as number, dimensions, absolute and/or relative vertical and/or horizontal position as well as material of the above mentioned constituents of the component carrier may be changed. The mutual interaction and/or relation between said constituents may be considered during the modification. After modification, simulation may be repeated with the modified parameters. Modifications leading to an improvement of simulated stress may be accepted, modifications leading to a deterioration of the simulated stress may be rejected. Modifying parameter values may be repeated once or multiple times. Hence, an iteration of modifications may be carried out until an acceptable configuration of the component carrier 100 has been found. This can be the case when compliance with a predefined specification, compliance with a predefined threshold stress and/or at least one other acceptance criteria is fulfilled. Preferably, the virtually modifying (according to block 206) may comprise horizontally shifting at least one of the stacked vertical connection elements 118-119 of a respective one of the at least one internal stack 116-117 away from a virtual connection axis 112 passing through centers 114 of a pair of adjacent external connecting elements 108. For instance, such a shifting may be accomplished as described above referring to Figures 1 to 9, 11, 13 to 20. Additionally or alternatively, it may also be possible to take the measures described for instance referring to Figure 10 or Figure 12 for reducing stress.

As shown in a block 208, the method may comprise physically manufacturing 208 the component carrier 100 using the modified parameterized position, shape and/or dimensions. For this purpose, it may be possible to transmit a data set of changed by the above processing stages to a component carrier manufacturing plant. In the component carrier manufacturing plant, a component carrier 100 (for instance an integrated circuit substrate) can then be produced as a hardware piece in compliance with the previous theoretical development process, for instance in accordance with the specification of said data set. In other words, the result of the previous analysis may lead to a set of parameters defining physical properties of the physically manufactured component carrier 100. As a result, a specific component carrier 100 may be obtained which can be used for a desired application. In particular, the design and manufacturing method may lead to the manufacture of a component carrier 100 having the above-mentioned features, i.e. having in particular at least one of the features described above referring to Figure 1 to Figure 21 relating to the relationship between conductive external connecting elements 108 and one or more internal stacks 116-117 of stacked vertical connection elements 118-119.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention, whose scope is defined by the appended claims, even in the case of fundamentally different embodiments.

## Claims

1. A component carrier (100), which comprises:
a layer stack (102) which comprises at least one electrically conductive layer structure (104) and at least one electrically insulating layer structure (106);
a plurality of electrically conductive external connecting elements (108) on and/or in one main surface (110) of the layer stack (102), wherein each pair of adjacent ones of said plurality of external connecting elements (108) are horizontally separated by a spacing (L) extending along a virtual connection axis (112) passing through centers (114) of both adjacent external connecting elements (108) of each respective pair; and
at least one internal stack (116, 117) of stacked vertical connection elements (118, 119), the internal stack (116, 117) extending internally of the layer stack (102), said stacked vertical connection elements (118, 119) being directly connected to an electrically conductive exterior surface (126) of the layer stack (102) in contact with a respective one of said external connecting elements (108);
wherein at least one of the stacked vertical connection elements (118, 119) of a respective one of the at least one internal stack (116, 117) is horizontally shifted away from the virtual connection axis (112), for example with respect to at least one other of the stacked vertical connection elements (118, 119) of said internal stack (116, 117).

2. The component carrier (100) according to claim 1, wherein a plurality of the stacked vertical connection elements (118, 119) overlap, in particular are aligned with, the virtual connection axis (112).

3. The component carrier (100) according to any of claims 1 or 2, wherein a sub-set of the stacked vertical connection elements (118, 119) which are located closer to the external connecting elements (108) in a viewing direction corresponding to a layer stack thickness direction (122) than another sub-set of the stacked vertical connection elements (118, 119) overlap, in particular are aligned with the virtual connection axis (112).

4. The component carrier (100) according to any of claims 1 to 3, wherein one of the at least one electrically conductive layer structure (104) electrically connects one, some or all of the at least one shifted stacked vertical connection elements (118, 119).

5. The component carrier (100) according to any of claims 1 to 4, wherein a first sub-set of said stacked vertical connection elements (118, 119) overlap each other in a viewing direction corresponding to a layer stack thickness direction (122), and a second sub-set of other ones of said stacked vertical connection elements (118, 119) are shifted and overlap each other in the viewing direction corresponding to the layer stack thickness direction (122).

6. The component carrier (100) according to any of claims 1 to 5, wherein the at least one shifted of the stacked vertical connection elements (118, 119) is arranged more centrally in layer stack thickness direction (122) than at least one other, in particular non-shifted, of the stacked vertical connection elements (118, 119) being arranged more peripherally in layer stack thickness direction (122).

7. The component carrier (100) according to any of claims 1 to 6, wherein at least one of said vertical connection elements (118, 119) located closer to a respective external connecting element (108) is located closer to a center (114) of said external connecting element (108) in a viewing direction corresponding to a layer stack thickness direction (122) than at least one of said vertical connection elements (118, 119) located further away from said external connecting element (108), wherein in particular the at least one of said vertical connection elements (118, 119) located closer overlaps, in particular fully overlaps, in the viewing direction corresponding to the layer stack thickness direction (122), with the horizontal extension of said external connecting element (108).

8. The component carrier (100) according to any of claims 1 to 7, wherein one, two or more of the stacked vertical connection elements (118, 119) being located closest to a respective external connecting element (108) is or are vertically aligned with said external connecting element (108) in a layer stack thickness direction (122), wherein in particular said one, two or more of the stacked vertical connection elements (118, 119) and the respective external connecting element (108) are coaxial and/or overlap with each other with an overlapping area being at least 80% of the entire area of the respective vertical connection element (118, 119) in a viewing direction corresponding to the layer stack thickness direction (122).

9. The component carrier (100) according to any of claims 1 to 8, wherein at least one of one or more central layers of the layer stack (102) comprises at least one conductive through connection (119) passing through the respective central layer, said at least one conductive through connection (119) belonging to or being connected to the stacked vertical connection elements (118, 119).

10. The component carrier (100) according to claim 9, wherein at least one conductive through connection (119) is horizontally shifted away from the virtual connection axis (112).

11. The component carrier (100) according to claim 9 or 10, wherein two internal stacks (116, 117) of stacked vertical connection elements (118, 119) are connected to or encompass a common conductive through connection (119), wherein in particular one internal stack (116, 117) overlaps, in particular along the virtual connection axis (112), and/or is coaxially centered with the conductive through connection (119) in a viewing direction corresponding to a layer stack thickness direction (122), wherein more particularly the other internal stack (116, 117) overlaps, in particular along the virtual connection axis (112), and/or is coaxially centered with the conductive through connection (119) in the viewing direction corresponding to a layer stack thickness direction (122).

12. The component carrier (100) according to claim 11, wherein the other internal stack (116, 117) does not overlap and/or is not coaxially centered with the conductive through connection (119) in the viewing direction corresponding to a layer stack thickness direction (122).

13. The component carrier (100) according to any of claims 11 to 12, wherein the internal stacks (116, 117) are symmetric with respect to a vertical plane encompassing the virtual connection axis (112) between the pair of external connecting elements (108).

14. The component carrier (100) according to any of claims 11 to 13, wherein the internal stacks (116, 117) extend at least partially through a core (132) of the layer stack (102) and/or extend at least partially through one or two build-up structures (128, 130) on opposing sides of a core (132) of the layer stack (102), wherein in particular the internal stacks (116, 117) are shifted in a horizontal plane at one or both of said build-up structures (128, 130).

15. The component carrier (100) according to claim 14, wherein at least one of the stacked vertical connection elements (118, 119) in one build-up structure (128, 130) is shifted in a horizontal plane away from the virtual connection axis (112) with respect to other ones of the stacked vertical connection elements (118, 119) on the opposing build-up structure (128, 130).
